# EUROPEAN PATENT APPLICATION

(11) **EP 4 391 037 A1**
(43) Date of publication of application: **26.06.2024**
(21) Application number: 22214863.7
(22) Date of filing: 20.12.2022
(51) Int. Cl.: H01L 21/822, H01L 21/8238, H01L 27/06, H01L 27/092, H01L 29/06, H01L 29/66, H01L 29/775, H01L 29/786

(54) **A METHOD FOR FORMING A SEMICONDUCTOR DEVICE**

(71) Applicant: Imec VZW, 3001 Leuven (BE); Katholieke Universiteit Leuven KU Leuven Research & Development, 3000 Leuven (BE)
(72) Inventor: CHAN, Boon Teik, 3012 Wilsele (BE); SALAHUDDIN, Shairfe Muhammad, 3010 kessel Lo (BE); RYCKAERT, Julien, 1030 Schaerbeek (BE); CHEHAB, Bilal, 3000 Leuven (BE); LIU, Hsiao-Hsuan, 3001 Leuven (BE)
(74) Representative: AWA Sweden AB

(57) **Abstract**

The disclosure relates to a method for forming a semiconductor device, comprising:
forming a device structure (400) on a substrate (102), the device structure comprising:
a device layer stack comprising a bottom device sub-stack comprising at least one bottom channel layer (124), and a top device sub-stack comprising at least one top channel layer,
a sacrificial gate structure extending across the device layer stack, and
bottom source/drain structures (126a, 126b) on opposite ends of the at least one bottom channel layer;

forming an opening exposing the top device sub-stack, wherein forming the opening comprises etching the sacrificial gate structure;
forming a cut through the top device sub-stack by etching back the top device sub-stack from the opening, wherein the etching extends through each of the at least one top channel layer and is stopped over the bottom device sub-stack; and
subsequent to forming the cut, forming a functional gate stack (480) on the at least one bottom channel layer.

## Description

### Technical field

The present disclosure relates to a method for forming a semiconductor device.

### Background

In the strive to provide ever more area-efficient circuit designs, vertically stacked transistor devices are being developed. One notable example is the Complementary field-effect transistor (CFET) device in which two horizontal channel transistors of complementary conductivity types are stacked on top of each other (e.g. a pFET bottom device and an nFET top device, or vice versa). The CFET device allows a reduced footprint compared to a traditional side-by-side arrangement of a pFET and nFET. The two device levels provided by the CFET (e.g. a "2-level middle-of line / MOL") further enables a reduced routing layer usage in the back-end-of line (BEOL). The CFET is hence an enabler for area-efficient Complementary Metal-Oxide Semiconductor (CMOS) circuitry.

Using what may be referred to as a "monolithic" process, a CFET device may be formed by patterning a deposited stack of channel layers top-down to form stacks of channel layers (e.g. into the form of nanosheets) for both the bottom device and the top device. After processing source and drain structures (e.g. by epitaxy) and forming source and drain contacts for the bottom and top devices, the channel layers of the bottom and top devices may be provided with a gate stack. The gate stack may also be formed in a "monolithic" process wherein the gate patterning for the top and bottom device is performed simultaneously. The CFET device may in particular be provided with a gate which is shared by, i.e. common to, the bottom and top devices.

Some integrated circuits require a combination of CMOS and non-CMOS devices. Examples include, but are not limited to, SRAM bit cells, latches and flip-flops which include, in addition to CMOS devices (e.g. CMOS inverter pairs), a pass gate or pass transistor. In a CFET device with a common gate electrode, either the nFET or pFET will be on regardless of a high or low logic level gate voltage. A pass gate function may hence not be provided by a typical CFET device.

### Summary

In light of the above, it would be desirable to provide a method allowing fabrication of a non-stacked transistor device (e.g. non-stacked device such as a pass gate) from a device structure for a stacked transistor device (e.g. a stacked CMOS device such as a CFET device) in a reliable and efficient manner. Further and alternative objectives may be understood from the following.

According to an aspect there is provided a method for forming a semiconductor device, comprising:
forming a device structure on a substrate, the device structure comprising:
   a device layer stack comprising a bottom device sub-stack comprising at least one bottom channel layer, and a top device sub-stack comprising at least one top channel layer,
   a sacrificial gate structure extending across the device layer stack, and
   bottom source/drain structures on opposite ends of the at least one bottom channel layer;
forming an opening exposing the top device sub-stack, wherein forming the opening comprises etching the sacrificial gate structure;
forming a cut through the top device sub-stack by etching back the top device sub-stack from the opening, wherein the etching extends through each of the at least one top channel layer and is stopped over the bottom device sub-stack; and
subsequent to forming the cut, forming a functional gate stack on the at least one bottom channel layer.

The present method is based on the insight that a non-stacked transistor device may be formed by supplementing processing steps for forming a stacked transistor device structure with steps for removing the channel layer(s) of the top device sub-stack.

More specifically, the method enables removal of the top device channel layer(s) of a stacked transistor device structure by etching a cut through the one or more top channel layers of the top device sub-stack. By cutting the top channel layer(s), formation of an active device on the top device sub-stack may hence be prevented.

By forming the cut via the opening in the sacrificial gate structure, the cut may be etched in a self-aligned manner with respect to an active region or channel region of the device structure. In other words, the reliance on the sacrificial gate structure imposes a constraint on the position of the cuts, thus facilitating area selective formation of non-stacked transistor devices.

Since the etching of the cut is stopped over the bottom device sub-stack, the bottom channel layer(s) is/are preserved (i.e. not cut or etched) such that a non-stacked transistor device may be formed at the bottom device sub-stack (a bottom transistor device).

The device layer stack may be formed in the shape of a fin structure. The term "fin structure" as used herein refers to a fin-shaped structure with a longitudinal dimension oriented in a horizontal direction (e.g. a "first" horizontal direction) along the substrate and protruding vertically therefrom.

The bottom and top device sub-stacks refer to one or more layers forming part of the device layer stack. The top device sub-stack is stacked on top of the bottom device sub-stack. Each one of the bottom and top device sub-stacks may comprise at least one (bottom/top) channel layer. Each one of the bottom and top device sub-stacks may however also comprise more than one channel layer stacked on top of each other. Each (bottom/top) channel layer may be a horizontally oriented channel layer, such as a (bottom/top) channel nanosheet.

Relative spatial terms such as "vertical", "upper", "lower", "top", "bottom", "above", "under", "below", are herein to be understood as denoting locations or orientations within a frame of reference of the substrate. In particular, the terms may be understood as locations or orientations along a normal direction to the substrate (i.e. a main plane of extension of the substrate). Correspondingly, terms such as "lateral" and "horizontal" are to be understood as locations or orientations parallel to the substrate (i.e. parallel to the main plane of extension of the substrate).

After forming the cut, the functional gate stack may be formed on (e.g. along and/or around depending on the device/channel geometry) the at least one bottom channel layer, as replacement for the sacrificial gate structure. The functional gate stack may be formed using a replacement metal gate (RMG) process.

The bottom source/drain structures may be formed subsequent to forming the sacrificial gate structure and prior to forming the opening and the cut. The bottom source/drain structures may be formed by epitaxy.

The device structure may further comprise top source/drain structures on opposite ends of the at least one top channel layer of the top device sub-stack of the device layer stack. The top source/drain structures may be formed by epitaxy. The top source/drain structures may be formed prior to forming the opening and the cut. The top source/drain structures may alternatively be formed subsequent to forming the opening and the cut, in accordance with some embodiments as further set out below.

The device structure may further comprise an insulating liner layer covering the device layer stack, wherein forming the opening further may comprise opening the insulating liner layer to expose the device layer stack, and thereafter forming the cut.

In some embodiments, the device layer stack may further comprise a dielectric separation layer intermediate the bottom and top device sub-stacks, and wherein the etching for forming the cut through the top device sub-stack may be stopped over or at the separation layer. The dielectric separation layer may increase a process margin for the cut formation, such that unintentional etching of the bottom channel layer(s) during the cut formation may be avoided. In particular, the dielectric separation layer may be used as an etch stop layer for the etching of the cut.

In some embodiments, the separation layer may alternatively be formed of a sacrificial semiconductor material, wherein the etching for forming the cut through the top device sub-stack may be stopped over or at the separation layer. The sacrificial separation layer may increase a process margin for the cut formation, such that unintentional etching of the bottom channel layer(s) during the cut formation may be avoided. In particular, the sacrificial separation layer may be used as an etch stop layer for the etching of the cut. It is hereby to be understood that the sacrificial semiconductor material is a material different from a channel material of the top (and optionally also bottom) channel layer(s). The method may further comprise removing the sacrificial separation layer by selective etching of the sacrificial semiconductor material, after forming the cut and prior to forming the functional gate stack. The separation layer may hence be removed to facilitate access to bottom device sub-stack (e.g. for the purpose of gate stack formation).

In some embodiments, the device layer stack may be a first device layer stack, and the sacrificial gate structure may be a first sacrificial gate structure, wherein the device structure may further comprise:
a second device layer stack comprising a bottom device sub-stack comprising at least one bottom channel layer, and a top device sub-stack comprising at least one top channel layer, and
bottom source/drain structures on opposite ends of the at least one bottom channel layer of the bottom device sub-stack of the second device layer stack,

wherein the first sacrificial gate structure, or a second sacrificial gate structure parallel to the first sacrificial gate structure, extends across the second device layer stack;
and the method further comprises:
   forming by epitaxy top source/drain structures on opposite ends of the at least one top channel layer of the top device sub-stack of the second device layer stack, and
   subsequent to forming the cut through the top device sub-stack of the first device layer stack, forming a functional gate stack on the at least one bottom channel layer and the at least one top channel layer of the bottom device sub-stack of the second device layer stack.

A combination of stacked and non-stacked transistor devices may hence be formed on the substrate. By forming the cut selectively through the top device sub-stack of the first device layer stack (and not through top device sub-stack of the second device layer stack) a stacked transistor device (comprising a bottom transistor device and a top transistor device) may be formed at bottom and top device sub-stacks of the second device layer stack and a non-stacked transistor device may be formed at bottom device sub-stack of the first device layer tack.

The top source/drain structures may be formed on the top channel layer(s) of the second device layer stack prior to forming the opening and the cut. The top source/drain structures may alternatively be formed subsequent to forming the opening and the cut, in accordance with some embodiments as further set out below.

In some embodiments, the opening may be formed to expose a top surface of the device layer stack and sidewalls of the bottom and top device sub-stack, and the method may further comprise forming in the opening a bottom mask layer surrounding the bottom device sub-stack, and using the bottom mask layer as an etch mask for the bottom device sub-stack during the forming of the cut. The bottom device sub-stack, in particular the bottom channel layer(s) thereof, may thus be masked from the etching of the cut. By the sacrificial gate structure extending across the device layer stack, it follows that the sacrificial gate structure may comprise a portion straddling the device layer stack. It is envisaged that at least this "straddling" portion of the sacrificial gate structure may be removed to form the opening. However, it is also possible to form the opening by removing the entire sacrificial gate structure (i.e. along its full length).

Forming the bottom mask layer may comprise filling the opening with a mask material and etching back the mask material to a level (above the substrate) intermediate the at least one top channel layer and the bottom device sub-stack, wherein the etched back mask material forms the bottom mask layer. The bottom mask layer may hence be reliably formed with a precise control of its thickness. In particular, a thickness of the etched back mask material / bottom mask layer may be such that the top device sub-stack is exposed over an upper surface of the etched back mask layer and the bottom device sub-stack is embedded by the bottom mask layer.

The method may further comprise removing the bottom mask layer after forming the cut and prior to forming the functional gate stack.

The bottom mask layer may be an organic material layer, such as an organic planarizing layer (e.g. an organic spin-on-layer). An organic / carbonbased material may be etched with a high selectivity to semiconductor material of the channel layers (and sacrificial layers if any), and to dielectrics typically used for gate spacers and sacrificial gate (hard mask) caps.

In some embodiments, the opening may be formed to selectively expose a top surface portion of the device layer stack, such that portions of the sacrificial gate structure remain along sidewalls of the bottom and top device sub-stack after forming the opening. The remaining portions of the sacrificial gate structure may thus be used as an etch mask for the bottom device sub-stack during the forming of the cut.

The method may further comprise:
forming a cut mask layer over the device structure;
patterning an aperture in the mask layer; and
sequentially transferring the aperture into the sacrificial gate structure and into the top device sub-stack by etching to form the opening and the cut.

The opening and the cut may hence be formed using a common etch mask, namely the patterned cut mask layer.

To avoid exposing sidewalls of the bottom and top device sub-stack, the aperture may be formed with a width less than a width of the device layer stack. "Width" hereby refers to a width of the aperture and a width of the device layer stack, respectively, as seen along a longitudinal direction of the gate structure.

The method may further comprise filling the opening in the sacrificial gate structure and the cut with a dielectric fill material and subsequently removing the sacrificial gate structure. The opening and the cut may hence "plugged" with a dielectric ("a dielectric plug"). The dielectric plug may among others counteract deposition of gate material in the cut. A vertical dimension/height of the gate stack over the bottom channel layer(s) may hence be reduced. The thusly created vertical space may be used to accommodate conductive features such as metal lines over the gate stack of the resulting (non-stacked) transistor device.

In some embodiments, the method may further comprise applying, via the cut, an isotropic etching process for removing portions of the top channel layers remaining along the cut. For various reasons (some of which are discussed in greater detail below) the etching of the cut may not entirely remove the top channel layer(s). Accordingly, the isotropic etching process enables removing such portions of the channel material / the at least one top channel layer remaining subsequent to forming the cut through the top device sub-stack.

For example, the device structure may further comprise a gate spacer formed on sidewalls of the sacrificial gate structure, wherein the isotropic etching process may remove end portions of each of the at least one top channel layer remaining below the gate spacer after forming the cut.

The top device sub-stack may also comprise a number of top channel layers and a number of sacrificial layers alternating the top channel layers, wherein end portions of the sacrificial layers are recessed with respect to the end portions of the channel layers and covered by insulating inner spacer portions, wherein the isotropic etching process may remove the end portions of each of the at least one top channel layer remaining below the inner spacer portions after forming the cut.

The isotropic etching process after the cut formation may also advantageously be used in combination with the above-discussed embodiments comprising using the cut mask layer with a patterned aperture to form the opening and the cut, wherein the aperture may be formed with a smaller width than the device layer stack and remaining portions of the channel layer remaining along the cut may be removed by isotropic etching.

The device structure may further comprise a fin structure comprising the first device layer stack and the second device layer stack, wherein the second sacrificial gate structure extends across the second device layer stack, and wherein one of the bottom source/drain structures is a merged epitaxial source/drain structure formed between the first and second sacrificial gate structures on the respective at least one bottom channel layer of the first and the second device layer stack, wherein the method may further comprise:
applying, via the cut, an isotropic etching process for removing portions of each of the at least one top channel layer of the first device layer sub-stack remaining along the cut; and
subsequent to applying the isotropic etching process, forming the top source/drain structures on opposite ends of the at least one top channel layer of the top device sub-stack of the second device layer stack.

The first and second device layer stacks may hence form part of a same fin structure, and thus be arranged along a same "fin track". The method enables a non-stacked and a stacked transistor device to be formed one after another along a same fin structure. By removing remaining portions of the top channel layer(s) of the first device layer sub-stack along the cut, deposition/epitaxy of source/drain material on remaining channel material of the top channel layer(s) (e.g. end portions preserved underneath the gate spacer and/or inner spacers) may be avoided, such that top source/drain structures may be formed selectively on the ends of the top channel layer(s) of the second device layer stack. This increases the space available for the top source/drain contacts between the first and second device layer stacks, e.g. facilitating wrap-around top source/drain contact formation.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Figs. 1-10 illustrate steps for forming a semiconductor device in accordance with a first method.
Figs. 11-14 illustrate steps for forming a semiconductor device in accordance with a second method.
Fig. 15 schematically illustrates an issue with merged epitaxial top source/drain structures.
Figs. 16-21 illustrate steps for forming a semiconductor device in accordance with a third method.

### Detailed description

Methods for forming a semiconductor device will now be described with reference to the figures. To facilitate understanding, reference will mainly be made to a single stacked transistor device structure on a substrate. It is however to be noted that the method may be applied in parallel to any number of stacked transistor device structures which may be formed on the substrate. The method steps providing removal of the top device channel layer(s) from a stacked transistor device structure may in particular be applied selectively to any number of stacked transistor device structures formed on the substrate, e.g. in parallel / simultaneously, such that one or more non-stacked transistor devices may be formed adjacent to stacked transistor devices.

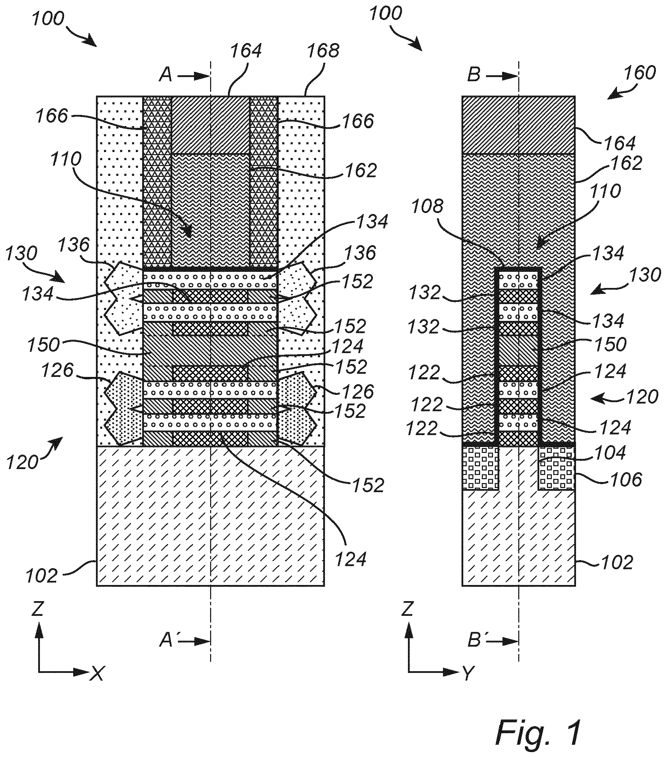

A first method will now be described with reference to Figs. 1-10 schematically illustrating a device structure 100 at various stages of the method. The left-hand view shows a first cross-section of the device structure 100 along line B-B' indicated in the right-hand view. The right-hand view shows a second cross-section of the device structure 100 along line A-A' indicated in the left-hand view. The X- and Y-axes indicate first and second horizontal directions, respectively, parallel to a main plane of a substrate 102 underneath the device structure 100. The Z-axis indicates a normal or vertical direction with respect to the substrate 102. The cross-sections and directions in subsequent figures correspond to those in Fig. 1, unless stated otherwise. Throughout the figures, like fill patterns will be used for like materials, unless stated otherwise.

Fig. 1 shows the device structure 100 at an initial or starting stage of the method. The device structure 100 is formed on a substrate 102. The substrate 102 may be a conventional semiconductor substrate suitable for CMOS processing. The substrate 102 may be a single-layered semiconductor substrate, for instance formed by a bulk substrate such as a Si substrate, a germanium (Ge) substrate or a silicon-germanium (SiGe) substrate. A multilayered / composite substrate is also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The device structure 100 comprises a device layer stack 110 comprising a bottom device sub-stack 120 and a top device sub-stack 130. The bottom device sub-stack 120 comprises a number of bottom channel layers 124 and the top device sub-stack 130 comprises a number of top channel layers 134.

The device layer stack 110 forms part of a fin structure, protruding in the Z-direction from the substrate 102, wherein the device layer stack 110 is arranged on top of a base portion 104 of the fin structure. The base portion 104 is surrounded by an interlayer dielectric forming a shallow-trench isolation (STI) 106, e.g. of SiO₂ or another conventional low-k dielectric suitable as STI.

The device structure 100 comprises a sacrificial gate structure 160 extending across the device layer stack 100. A longitudinal dimension of the sacrificial gate structure 160 is oriented in the Y-direction.

The device structure 100 comprises a pair of bottom source/drain structures 126 formed on opposite ends of the bottom channel layers 124, and a pair of top source/drain structures 136 formed on opposite ends of the top channel layers 134. The bottom channel layers 124 extend between the bottom source/drain structures 126 in the X-direction. This applies correspondingly to the top channel layers 134 and the top source/drain structures 136. The bottom source/drain structures 126 and the top source/drain structures 136 are formed on opposite sides of the sacrificial gate structure 160. As shown in Fig. 1, each one of the bottom source/drain structures 126 and the top source/drain structures 136 may be formed by merged source/drain portions formed on the respective channel layers 124, 134. The bottom source/drain structures 126 and the top source/drain structures 136 are hence depicted as continuous bodies. However, it is contemplated that the source/drain structures also may be formed without merging, wherein each one of the one of the bottom source/drain structures 126 and the top source/drain structures 136 may comprise a number (corresponding to the number of channel layers of the bottom and top device sub-stacks 120, 130) of physically separate source/drain portions formed on the respective channel layers 124, 134.

According to the illustrated example, each one of the bottom and top device sub-stacks 120, 130 comprises a respective stack of layers. The bottom sub-stack 120 comprises a number bottom sacrificial layers 122 alternating the bottom channel layers 124. The top sub-stack 130 correspondingly comprises a number top sacrificial layers 132 alternating the top channel layers 134. While the illustrated example shows two or three sacrificial layers and two channel layers in each of the bottom and top device sub-stacks 120, 130, this is merely an example and the number of sacrificial layers 122/132 and channel layers 124/134 may be varied. The number of sacrificial and channel layers in the bottom and top device sub-stacks 120, 130 may also be different.

The sacrificial layers 122/132 and the channel layers 124/134 may each be semiconductor layers formed of a sacrificial material and a channel material, respectively. The sacrificial material and the channel material may for instance be Si_{1-y}Ge_{y} and Si₁₋ₓGeₓ respectively, wherein 0 ≤ x < y. For example, y may be equal to or greater than x + d, where d ≥ 0.25. In one example, the sacrificial material may be SiGe_{0.25} and the channel material may be a Si. As per se is known in the art, a relative difference in Ge-content enables subsequent selective processing (e.g. selective etching) of the sacrificial layers 122/132 and the channel layers 124/134. For example, a SiGe layer with a greater concentration of Ge than another Si or SiGe layer may be etched selectively (i.e. at a greater rate) using an HCl-based dry etch or an ammonia peroxide mixture (APM). Other appropriate etching processes (wet or dry) allowing selective etching of higher Ge-content SiGe layers with respect to lower Ge-content SiGe (or Si) layers are per se known in the art and may also be employed for this purpose.

The sacrificial layers 122/132 and the channel layers 124/134 may each be formed as nanosheets, e.g. with a width (along Y) to thickness (along Z) ratio greater than 1, such as a width in a range from 10 nm to 30 nm and a thickness in a range from 3 nm to 10 nm. However, also other shapes are possible such as nanowire-shaped layers. A nanowire may by way of example have a thickness similar to the example nanosheet however with a smaller width, such as 3 nm to 10 nm.

Still with reference to Fig. 1, the device layer stack 110 further comprises a dielectric separation layer 150 intermediate the bottom and top device sub-stacks 120, 130. The dielectric separation layer 150 may for example be formed of an oxide- or nitride-based material, for instance of SiO₂, SiN, SiC, SiCO, SiCN or SiBCN or combinations thereof.

The sacrificial gate structure 160 comprises a sacrificial gate body 162 (e.g. of amorphous Si or another conventional material suitable for a sacrificial/dummy gate body) and a gate cap 164, e.g. of SiN, SiC, SiCO, SiCN or SiBCN or another suitable dielectric hard mask material. A gate spacer 166 is formed along the sidewalls of the sacrificial gate structure 160, e.g. on sidewalls of the sacrificial gate body 162 and the gate cap 164. The gate spacer 166 may be formed of dielectric material, e.g. a nitride or a carbide such as SiN, SiC, SiCO, SiCN or SiBCN, or combinations thereof. The gate spacer 166 may be formed of a different material than the gate cap 164 to facilitate etching of the gate cap 164 selectively to the gate spacer 166.

The bottom source/drain structures 126 and the top source/drain structures 136 may be formed as epitaxial (i.e. epitaxially grown) structures or bodies of doped semiconductor material. The bottom source/drain structures 126 and the top source/drain structures 136 may be oppositely doped to define bottom and top source/drain structures of opposite conductivity types (e.g. p-type bottom source/drain structures 126 and n-type top source/drain structures 136, or vice versa). Although omitted from Fig. 1, to not overly obscure the drawings, the source/drain structures 126, 136 may be provided with a dielectric contact etch stop layer (ESL), such as an ALD-deposited nitride- or carbide-based material.

The device structure 100 further comprises inner spacers 152, covering respective end portions of the sacrificial layers 122/132 recessed with respect to the end portions of the channel layers 124/134. The inner spacers 152 are formed by inner spacer material filling the recesses. Examples of inner spacer materials include dielectric materials, such as any of the materials mentioned in connection with the dielectric separation layer 150. As indicated by the dashed lines between dielectric separation layer 150 and inner spacers 152 in Fig. 1, the dielectric separation layer 150 and the inner spacers 152 may for example be formed of a same material. As per se is known to the skilled person, inner spacers may serve to facilitate subsequent process steps, such as a channel release step wherein the inner spacers may counteract etching of the source/drain structures 126, 136 during removal of the sacrificial layers 122, 132. The inner spacers may further provide physical and electrical separation between the source/drain structures 126, 136 and the final gate stack.

The device structure 100 comprises a dummy gate oxide 108 (e.g. of SiO₂) covering the device layer stack 110 (and optionally the STI 106). The sacrificial gate structure 160 is formed on the dummy gate oxide 108.

The device structure 100 comprises an interlayer dielectric layer 168 covering the bottom and top source/drain structures 126, 136 and surrounding the sacrificial gate structure 160 on either side. The interlayer dielectric layer 168 may be formed of an insulating material, such as an oxide, e.g. SiO₂, or another conventional low-k dielectric suitable as interlayer dielectric.

Fabrication of the device structure 100 as shown in Fig. 1 may proceed as follows:
A fin structure (e.g. a plurality of parallel fin structures) may be patterned in an initial layer stack comprising an initial bottom layer sub-stack (for forming the bottom device sub-stack 120) and an initial top layer sub-stack (for forming the top device sub-stack 130). The layers may be epitaxially grown using deposition techniques such as chemical vapor deposition (CVD) or physical vapor deposition (PVD). Conventional fin patterning techniques may be used, e.g. single patterning techniques such as lithography and etching ("litho-etch") or multiple-patterning techniques such as (litho-etch)^{x}, self-aligned double or quadruple patterning (SADP or SAQP).

The separation layer 150 may be formed using a sacrificial layer replacement process, wherein an intermediate sacrificial layer of the device layer stack 110 (e.g. after fin patterning, such as prior to or subsequent to forming the sacrificial gate structure 160) may be replaced with a dielectric material by removing the intermediate sacrificial layer in a selective etching process and refilling the thusly formed cavity in the fin structure with a dielectric using a conformal deposition process such as ALD. For example, in case of a Si/SiGe-based layer stack 110, the intermediate sacrificial layer may be formed of (e.g. of Si_{1-z}Ge_{z}, where z > y, such as z = y + d). The dielectric separation layer 150 may also be formed by patterning fin structures in an initial layer stack wherein the initial top device sub-stack may be formed on a separate wafer and subsequently be transferred and bonded to an initial dielectric separation layer using a wafer transfer and bonding process. The initial dielectric separation layer then be patterned together with the bottom and top device sub-stacks to form the dielectric separation layer 150.

The fin structure(s) may subsequently be covered by insulating material which may be recessed, e.g. by chemical mechanical polishing (CMP) and/or etch back, to expose the layer stack 110 and form the STI 106 surrounding the base portion 104 of the fin structure(s). A dummy gate oxide 108 may then be deposited over the fin structure(s), e.g. using ALD.

The fabrication may then proceed with sacrificial gate structure formation. A sacrificial gate layer (e.g. amorphous Si) may be deposited over the device layer stack 110 (e.g. using CVD or PVD). The sacrificial gate body 162 (e.g. a plurality of parallel sacrificial gate bodies) may then be patterned therein using single- or multiple-patterning techniques, as per se is known in the art. A hard mask used during the sacrificial gate layer patterning may be preserved on top of the sacrificial gate body 162 to form the gate cap 164. The gate spacer 166 may subsequently be formed by depositing a gate spacer material (e.g. using ALD). The gate spacer material may then be etched anisotropically (e.g. top-down) to remove the gate spacer material from horizontally oriented surfaces of the device structure 100 such that the gate spacer material remains on the vertically oriented sidewalls of the sacrificial gate body 162 and gate cap 164.

The fin structure(s) may subsequently be recessed by etching back the fin structures 104 in a top-down direction on either side of each sacrificial gate structure 160. Each fin structure may thereby be partitioned into a plurality of fin structure portions, each comprising a respective device layer stack corresponding to device layer stack 110. The etch-back may proceed through the top and bottom device sub-stacks 120, 130 and thus define end surfaces of the respective channel layers on either side of each sacrificial gate structure 160.

The bottom and top source/drain structures 126, 136 may then be formed, using an epitaxial process, on the end surfaces of the respective channel layers of the top and bottom device sub-stacks 120, 130. The bottom and top source/drain structures 126, 136 may for example be formed using area selective epitaxy such that bottom source/drain structures 126 and top source/drain structures 136 may be formed sequentially and with opposite dopant types. For example, area selective epitaxy may be facilitated by forming a temporary cover spacer to cover the end surfaces of the top channel layers 134 during the epitaxy of the bottom source/drain structures 120 on the exposed end surfaces of the bottom channel layers 124. The cover spacer may then be removed and a bottom cover layer may be formed to cover the bottom source/drain structures 126 during the epitaxy of the top source/drain structures 136.

Prior to the source/drain epitaxy, inner spacers 152 may be formed using an inner spacer formation process. An inner spacer formation process may comprise forming recesses using a lateral etch back (e.g. along the Xand negative X-directions) of end surfaces of each sacrificial layer 122/132 from opposite sides of the sacrificial gate structure 160 using an isotropic etching process (e.g. selective to the sacrificial material). Inner spacer material may be deposited with a thickness such that the recesses are pinched-off (i.e. closed) by the spacer material. The inner spacer material may for example be deposited using conformal deposition techniques such as ALD. Portions of inner spacer material deposited outside the recesses may subsequently be removed using a suitable etching process (anisotropic or isotropic, wet or dry) to expose end surfaces of the channel layers 124/134.

Subsequent to forming the source/drain structures 120, 130 an insulating material may be deposited (e.g. SiO₂ deposited by flowable-CVD) and recessed (e.g. by CMP and/or etch back) to form the interlayer dielectric layer 168, as shown in Fig. 1.

While in the illustrated example, both the bottom device sub-stack 120 and the top device sub-stack 130 comprises respective stacks of sacrificial and channel layers, the method is applicable also to device layer stacks with other layer structures. For example, the bottom device sub-stack 120 and/or the top device sub-stack 130 may comprise only a single channel layer and no sacrificial layers. This structure may be useful for forming bottom and/or top devices with only a single channel layer and without a gate-all-around. In a bottom and/or device sub-stack without sacrificial layers inner spacers may be omitted in the respective sub-stack, as would be understood by the skilled person.

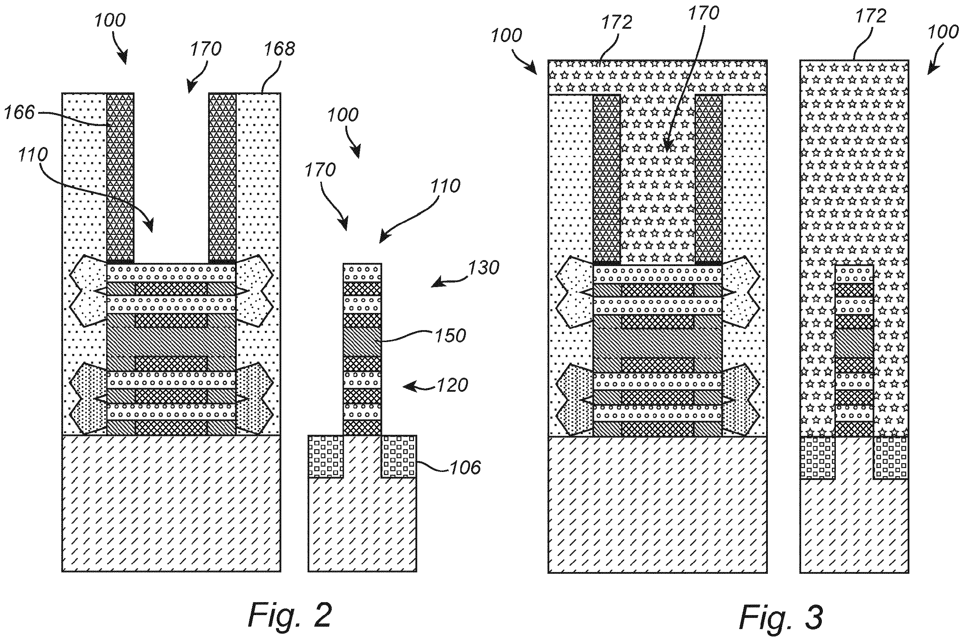

In Fig. 2, an opening 170 exposing the device layer stack 110 comprising the bottom device sub-stack 120 and the top device sub-stack has been formed. More specifically, the opening 170 exposes a top surface and sidewalls of the device layer stack 110, including the sidewalls of the bottom and top device sub-stacks 120, 130. The opening is formed by opening the gate cap 164 to expose and then remove the sacrificial gate body 162 by etching. The dummy gate oxide 108, if present, may be opened using a separate etch step to expose the device layer stack 110. The sacrificial gate structure 160 and sacrificial gate body 162 may be removed along its full length. However, it is also possible to remove only the portion of the sacrificial gate structure 160 straddling the device layer stack 110. In this case, a separate etch mask (e.g. a lithographic layer stack) may be formed and patterned to define an opening over the straddling portion which is to be removed. As may be appreciated, the sacrificial gate structure 160 may be removed (partially or in full) to form one or more openings exposing device layer stacks of parallel fin structures straddled by the same sacrificial gate structure 160. This may also be applied in parallel to any further sacrificial gate structures of the device structure 110.

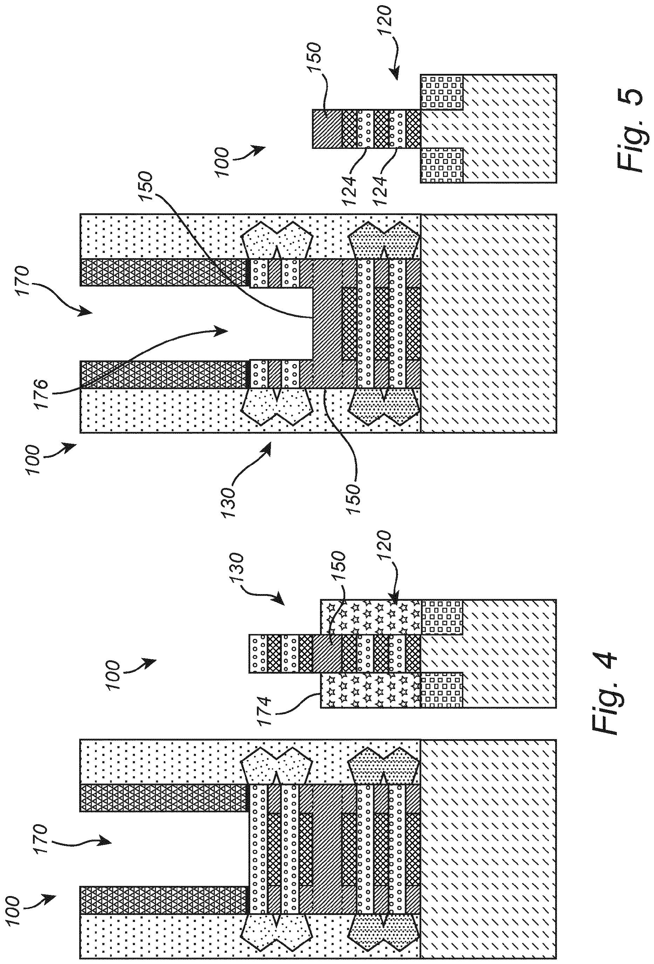

In Fig. 3 the opening 170 has been filled with a mask material 172 and in Fig. 4 etched back (optionally after CMP) to a vertical level above the substrate 102 coinciding with (e.g. within) the dielectric separation layer 150, thereby forming a bottom mask layer 174. A thickness of the bottom mask layer 174 is such that the bottom device sub-stack 120 is surrounded by the mask layer 174 and the top device sub-stack is exposed over an upper surface of the mask layer 174. The bottom mask layer 174 may be an organic material layer, such as an organic material layer deposited using a CVD or spin-on process (e.g. an organic spin-on-layer).

In Fig. 5, a cut 176 extending through the top device sub-stack 130 has been formed by etching back the top device sub-stack 130 from the opening 170. The etching and thus the cut 176 extends through each of the top channel layers 134 and the top sacrificial layers 132 and is stopped over the bottom device sub-stack 120. The cut 176 may be etched using a suitable etching process, isotropic or anisotropic, wet or dry. During the etching of the cut 176, the bottom mask layer 174 is used as an etch mask for the bottom device sub-stack 120, e.g. by masking the bottom device sub-stack 120 from the sides. Meanwhile, the dielectric separation layer 150 may act as an etch mask, masking the bottom device sub-stack 120 from above. The dielectric separation layer 150 may in particular be used as an etch stop layer. It is however also possible to stop the etching of the cut 176 prior to the dielectric separation layer 150, such as on or within a bottom-most one of the top sacrificial layers 132. In any case, the etching does not extend into the bottom device sub-stack 120 and the bottom channel layers 124 are hence preserved underneath the cut 176.

By forming the cut 176, the top device channel layers 134 of the top device sub-stack 130 may accordingly be cut or removed (at least partially) such that forming an active top device during subsequent process steps is prevented. As the cut 176 is formed via the opening 170, the cut 176 may be self-aligned to an active region or channel region of the device structure 100. More specifically, the top channel layers 134 may be cut in a region in which otherwise an active region of a top transistor device may be formed.

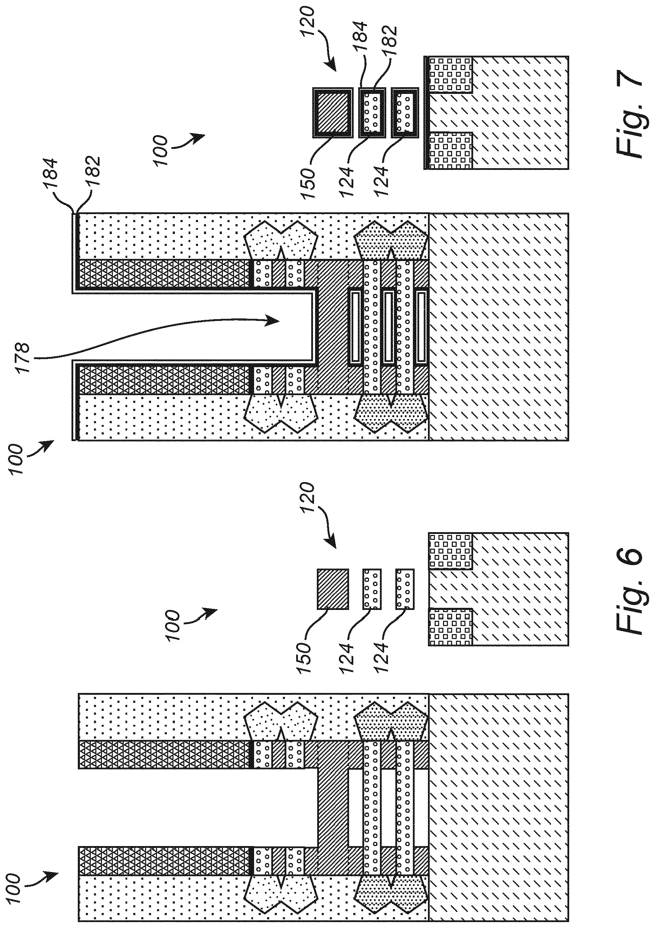

After forming the cut 176, the bottom mask layer 174 may be removed and the method may thereafter proceed with forming of a functional gate stack to replace the sacrificial gate structure 160, as will be described with reference to Figs. 6-10.

Fig. 6 shows the device structure 100 at a stage after performing a channel release process, prior to depositing the functional gate stack. In the channel release process, the bottom sacrificial layers 122 of the bottom device sub-stack are removed selectively to the bottom channel layers 124 of the bottom device sub-stack 120. The sacrificial layers 122 may be removed by etching the sacrificial material selectively to the channel material. A same type of etching process may be used for this step as during the forming of the recesses for the inner spacers 152. The channel layers 124 of the bottom device sub-stack 120 may thus be released in the sense that upper and lower surfaces thereof may be exposed.

The channel release process may be preceded by removing any portions of the sacrificial gate structure 160 remaining following forming the opening 170 (e.g. in case the sacrificial gate structure 160 was only partially removed), as well as any remaining further sacrificial gate structures (or portions thereof) of the device structure 110, thereby exposing all corresponding device layer stacks (with cut or uncut top device sub-stacks) for the channel release process.

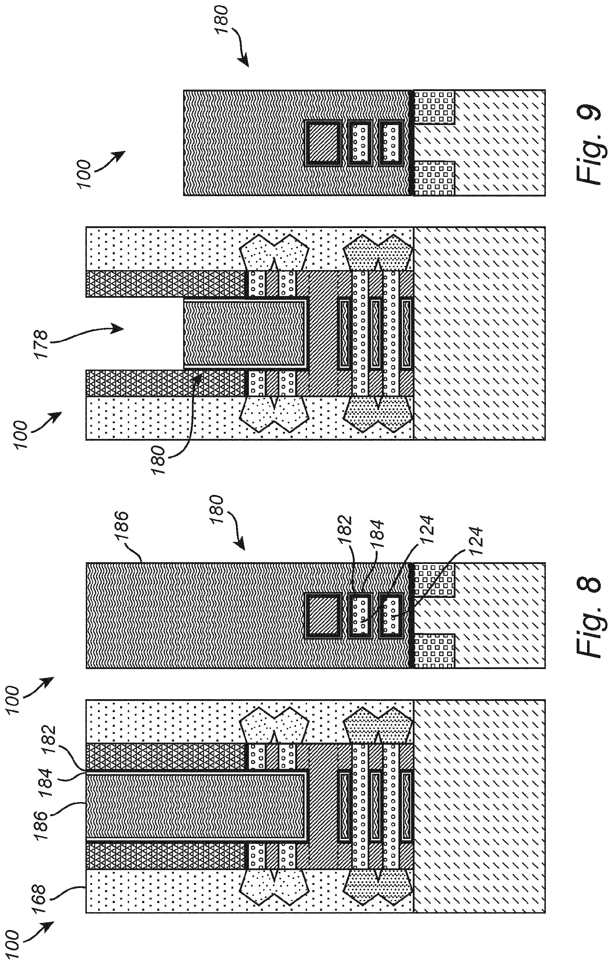

In Figs. 7-8 a functional gate stack 180 has been deposited in the cavity 178 (e.g. "gate trench") formed by removing the sacrificial gate structure 160 and the sacrificial layers 122. In Fig. 7, a gate dielectric layer 182 and then a gate work function metal (WFM) 184 have been conformally deposited (e.g. using ALD) on and around the channel layers 124. The gate dielectric layer 182 may be formed of a conventional a high-k dielectric e.g. HfO₂, HfSiO, LaO, AlO or ZrO. The WFM 184 may be formed of one or more effective WFMs (e.g. an n-type WFM such as TiAl or TiAlC and/or a p-type WFM such as TiN or TaN). In Fig. 8, a gate fill metal 186 (such as W, Al, Co or Ru) has been deposited to fill a remaining space of the gate trench 178. The gate fill metal 186 may for instance be deposited by CVD or PVD and subsequently be planarized and recessed (e.g. by CMP and/or metal etch back) to remove portions of the gate stack 180 deposited outside the gate trench 178 and expose an upper surface of the interlayer dielectric layer 168.

In case stacked transistor devices (i.e. with uncut top device sub-stacks) with bottom and top transistor devices of complementary conductivity types (e.g. CFET devices) also are to be formed on the substrate 102, device performance of the stacked transistor devices may be optimized by implementing a CMOS/dual-WFM RMG process, wherein gate stacks with different effective WFMs for bottom and top channel layers may be formed. In a CMOS-RMG process, a first WFM (conformally deposited) may be removed selectively from the top channel layers using an isotropic metal etch process while masking the first WFM formed on the bottom channel layers using a block mask layer, e.g. formed in a manner similar to the bottom mask layer 174. After removing the bottom mask layer, a second WFM, or a stack of WFMs, may thereafter be deposited on the first WFM remaining on the bottom channel layers and on the top channel layers. The gate stack may then be completed by depositing a gate fill metal.

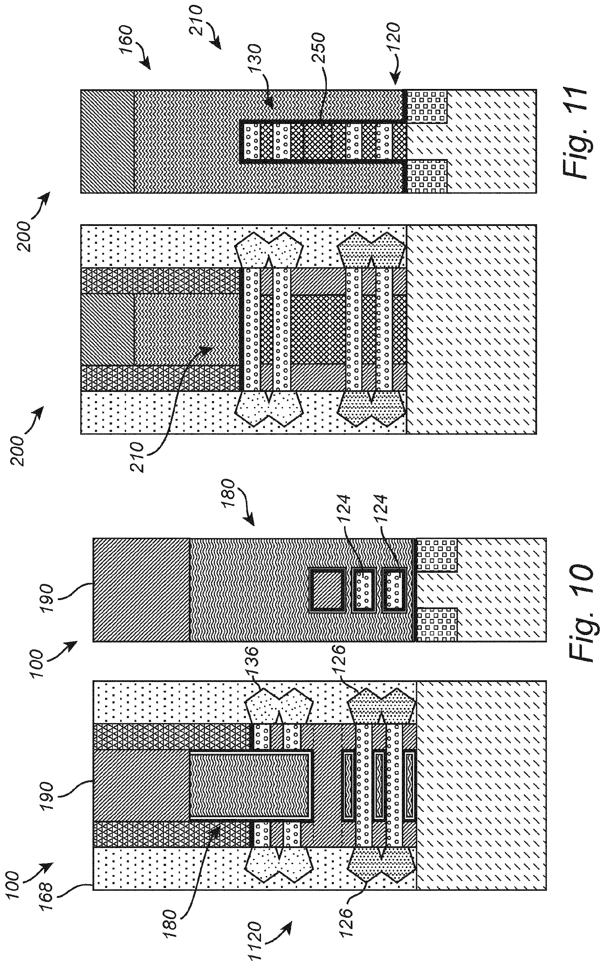

In Figs. 9-10, the gate stack 180 has been recessed (Fig. 9), e.g. using a metal etch back process, and then a dielectric gate cap 190 has been formed on the recessed gate stack 180 (Fig. 10). The dielectric gate cap 190 may be formed by an oxide- or nitride-based material (for instance of SiN, SiC, SiCO, SiCN or SiBCN) deposited to cover the recessed gate stack 180 and the interlayer dielectric layer 168, and then be recessed (e.g. by CMP) to expose the upper surface of the interlayer dielectric 168.

Fig. 10 thus shows a non-stacked transistor device structure 1120 (e.g. an nFET or a pFET) comprising bottom channel layers 124 of the bottom device sub-stack 120 extending between the bottom source/drain structures 126, and a gate stack 180 on the bottom channel layers 124. In the illustrated example, the top source/drain structures 136 remain but are disconnected from each other, due to the cutting of the top channel layers 134.

The method may thereafter proceed with further steps for forming final functional non-stacked transistor devices. For example source/drain contacts may be formed by etching contact trenches in the interlayer dielectric layer 168 and depositing one or more contact metals in the trenches, on the source and drain structures 126, 136, e.g. after opening an optional contact etch stop layer thereon. Separate contacting of the source and drain structures of adjacent stacked transistor devices (e.g. CFETs) may be achieved by a first contact metal deposition over the bottom and top source and drain structures, etch back of the contact metal to a level between the bottom and top source and drain structures, thus exposing the top source and drain structures, deposition of an insulating contact separation layer on the etched back contact metal, and subsequently a second contact metal deposition over the top source and drain structures. Separate source and drain contacting may be applied to either or both sides of a stacked transistor device.

It is contemplated that in case the top source/drain structures 136 of the non-stacked transistor device 1120 may be individually accessed with an etching process while masking top source/drain structures of adjacent stacked transistor devices, the top source/drain structures 136 of the non-stacked transistor device 1120 may be removed on one or both sides, prior to source/drain contact formation, for instance in connection with forming the contact trenches.

A second method for forming a semiconductor device will now be described with reference to Figs. 11-14. The method is generally similar to the first method, however differs in that the starting device structure 200 for the method comprises, instead of a dielectric separation layer 150, a separation layer 250 of a sacrificial semiconductor material intermediate the bottom device sub-stack 120 and the top device sub-stack 130. The separation layer 250 may for example be formed of a SiGe material with a same composition as the sacrificial layers 122 and/or 132. The device structure 200 is otherwise similar to the device structure 100 and like reference signs will be used to refer to like elements.

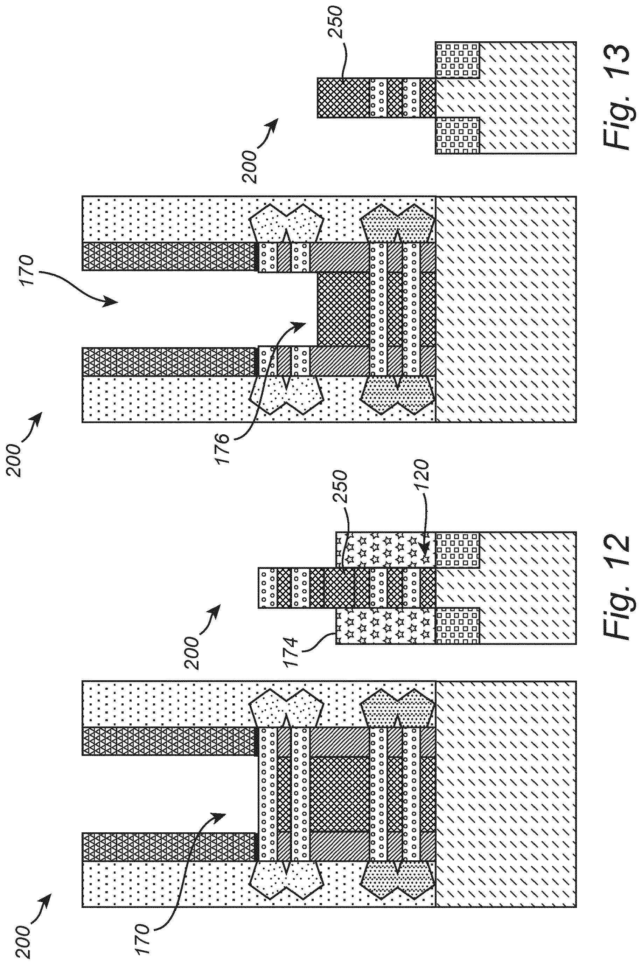

Fig. 12 depicts the device structure 200 after an opening 170 has been formed by etching the sacrificial gate structure 160 and after forming a bottom mask layer 174 surrounding the bottom device sub-stack 120.

Fig. 13 depicts the device structure 200 after a cut 176 has been etched through the top device sub-stack 130, stopping on or within the separation layer 250, and while using the bottom mask layer 174 as an etch mask for the bottom device sub-stack.

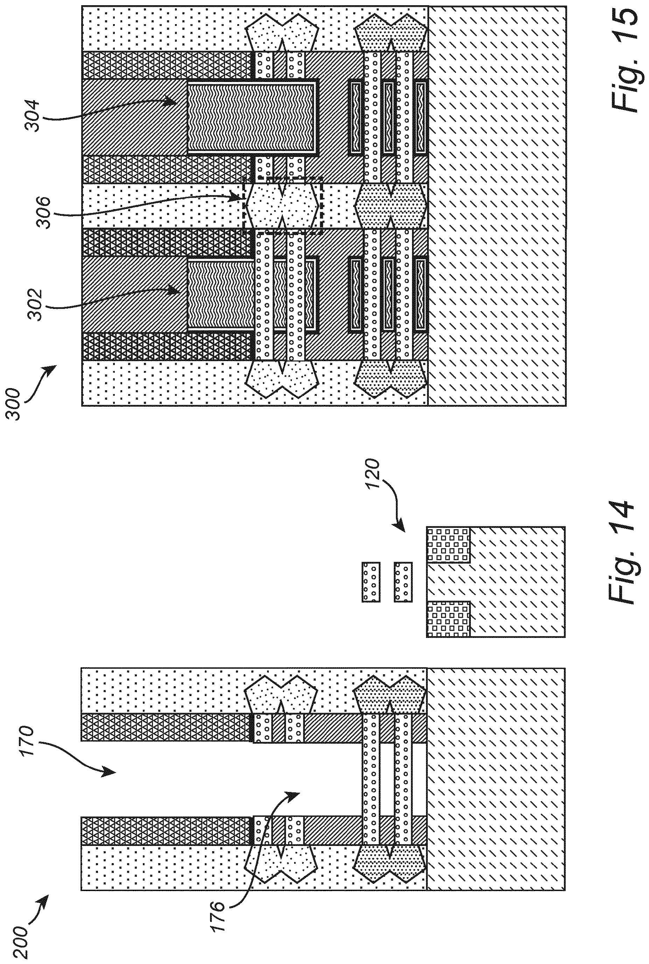

Fig. 14 depicts the device structure 200 after the channel release process. The etching of the channel release process may additionally remove portions of the separation layer 250 which may remain below the cut 176 (e.g. due to stopping the etch on or within the separation layer 250). The method may then proceed with forming of a functional gate stack as discussed with reference to Figs. 7-10 above.

Fig. 15 shows a cross-sectional view of a device structure 300 comprising a stacked transistor device 302 such as a CFET formed adjacent a non-stacked transistor device 304, formed e.g. in accordance with the first or second method described above. While the top device sub-stack of the non-stacked transistor device 304 has been cut, both the bottom and top source/drain structures of the stacked and non-stacked transistor devices 302, 304 are merged. While this may be desirable at the bottom device level (e.g. since the source/drain of the pass gate typically is connected to the source/drain of the complementary pair of transistors), merging also at the top device level may result in a reduced space for forming a source/drain contact (e.g. a wrap-around contact) on the top source/drain structure of the top device of the stacked transistor device 302. Due to the merging and the close proximity between the stacked and non-stacked transistor devices 302, 304, it may not be feasible to individually access the top source/drain structure of the non-stacked transistor device 304 with an etching process, without also removing the top source/drain structure of the stacked transistor device 302.

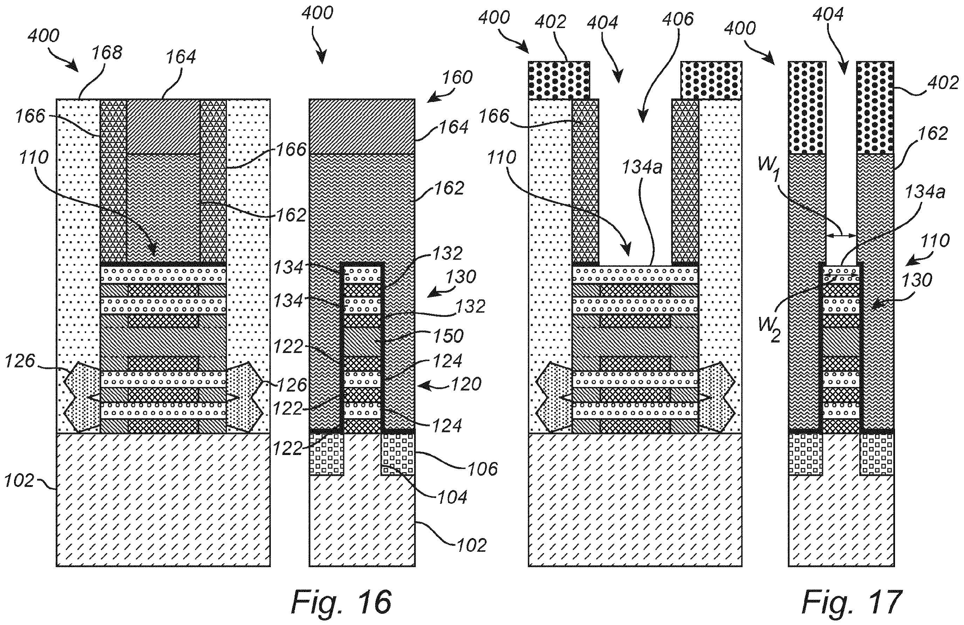

A third method for forming a semiconductor device will now be described with reference to Figs. 16-21. The third method enables avoiding an issue of merged epitaxial source/drain structures as shown in Fig 15. This is enabled: i) by performing the top source/drain structure epitaxy (i.e. on the stacked transistor devices) after forming the cut through selected top device sub-stacks; and ii) by removing channel material remaining along in the cut regions using an isotropic etching process.

Fig. 16 depicts a starting device structure 400 for the method. The device structure 400 is similar to the device structure 100 however differs in that the device structure 400 comprises only bottom source/drain structures 126 and no top source/drain structures.

In Fig. 17 an opening 406 has been formed by etching the sacrificial gate structure 160. In contrast to the first and second methods, the opening 406 is formed to selectively expose a top surface portion of the device layer stack 110. In the illustrated example the top surface portion is formed by a portion of a top surface of the topmost channel layer 134a. However, the exposed top surface portion may also be formed by a portion of a top-most sacrificial layer 132, in case a sacrificial layer 132 forms a top-most layer of the top device sub-stack 130.

The opening 406 is as shown in Fig. 17 formed by forming a cut mask layer 402 over the device structure 400 and patterning an aperture 404 in the mask layer 402 at a position over the device layer stack 110. The aperture 404 may be patterned using a lithography and etching process.

The aperture 404 is sequentially transferred into the sacrificial gate structure 160 by etching to form the opening 406 through the gate cap 164 and the sacrificial gate body 162. It is contemplated that a respective aperture may be pattered in the cut mask layer 402 in each region where a non-stacked transistor device is desired. Optionally, the gate cap 164 may be removed prior to forming the cut mask layer 402 and the opening 406.

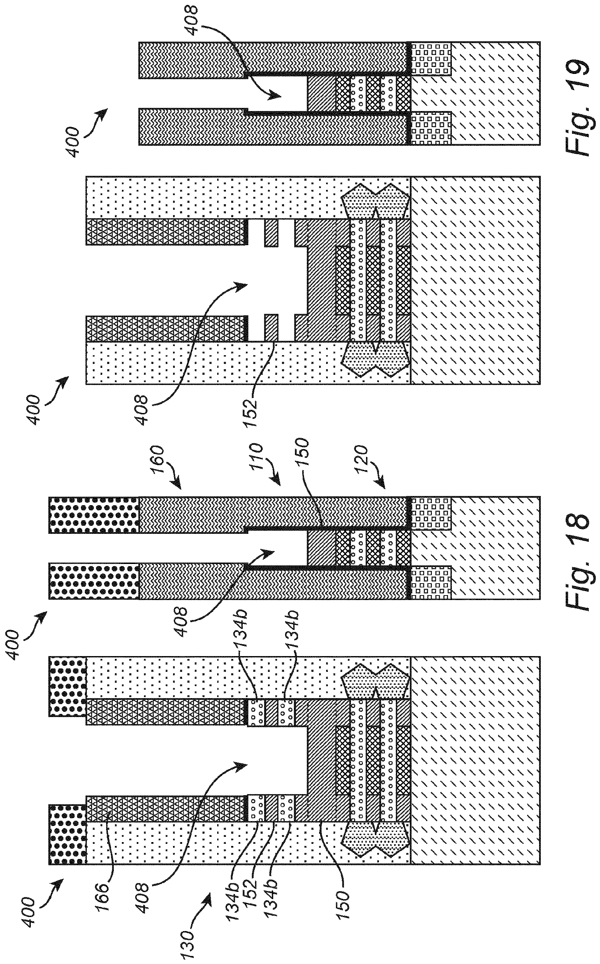

In Fig. 18, a cut 408 has been etched through the top device sub-stack 130, thus transferring the opening 406 into the top device sub-stack 130. The etching may as shown in Fig. 18 and as discussed in connection with the first method be stopped on the dielectric separation layer 150.

By the selective opening of the gate structure 160, portions of the sacrificial gate structure 160 may as shown remain along sidewalls of the bottom and top device sub-stack 120, 130 after forming the opening 406. The remaining portions of the sacrificial gate structure 160 may thus be used as an etch mask for the bottom device sub-stack 120 during the forming of the cut 408. This obviates the need for a bottom mask layer like layer 174 used in the first and second methods.

The aperture 404 and the opening 406 may as shown in Fig. 17 be formed with a width W₁ less than a width W₂ of the device layer stack 110. This may increase a margin against edge placement errors when patterning the cut mask layer 402, which otherwise could result in the opening 406 exposing a sidewall of the device layer stack 110.

In Fig. 19, portions of channel material of the channel layers 134 of the top device sub-stack 130 remaining after forming the cut 408 have been removed using an isotropic etching process. Remaining portions of channel material may include end portions 134b (see Fig. 18) masked by and thus preserved underneath the gate spacer 166 and the inner spacers 152. Portions of channel material may also remain as a result of the width W₁ of the opening 406 being smaller than the width W₂ of the device layer stack 110. The remaining portions of the sacrificial gate structure 160 may be used as an etch mask (together with the dielectric separation layer 150) for the bottom device sub-stack 120 also during the isotropic etching process.

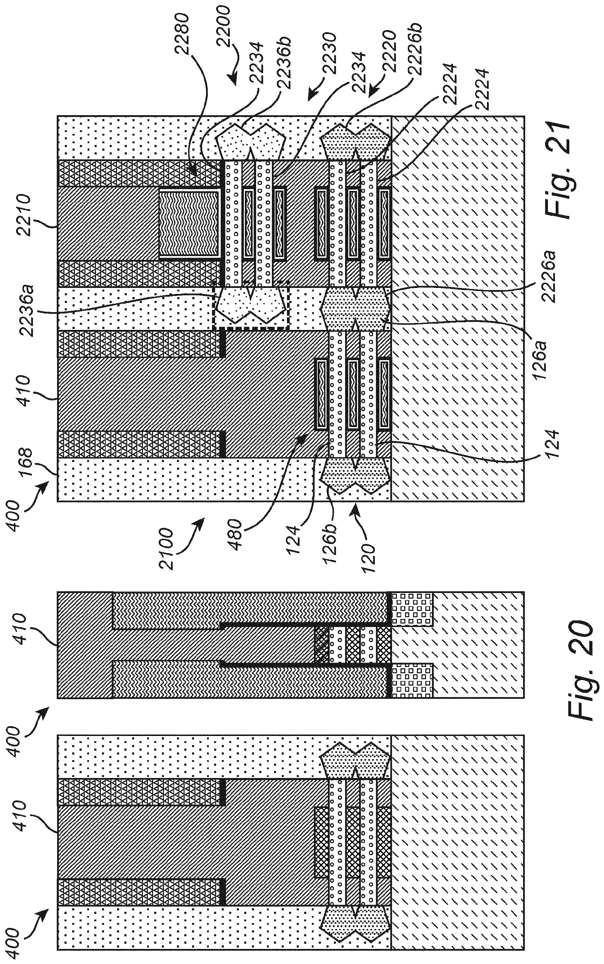

In Fig. 20, the opening 406 and the cut 408 have been filled or "plugged" with a dielectric fill material (e.g. any of the materials mentioned in connection with the gate cap 190 shown in Fig. 10) forming dielectric plug or cap 410. The fill material may be conformally deposited (e.g. using ALD) to facilitate a high fill ratio. Overburden dielectric fill material may be removed from the device structure 400 using CMP.

The method may then proceed with top source/drain epitaxy, to form top source/drain structures for stacked transistor devices. After top source/drain epitaxy, the method may proceed with removing remaining portions of the sacrificial gate structure 160, followed by channel release and functional gate stack deposition, in correspondence with the description provided in connection with the first method.

Fig. 21 depicts the resulting device structure 400 comprising a non-stacked transistor device 2100 (e.g. an nFET or a pFET) comprising the bottom channel layers 124 of the bottom device sub-stack 120 extending between the bottom source/drain structures 126a-b, and on the bottom channel layers 124 a gate stack 480 with the dielectric plug 410 on top. The gate stack 420 may have a same composition as the gate stack 180 discussed above. Additionally, the device structure 400 comprises a neighboring stacked transistor device 2200 (e.g. formed along a same fin as the non-stacked transistor device 2100). The stacked transistor device 2200 comprises: a bottom device sub-stack 2220 corresponding to the bottom device sub-stack 120 and comprising bottom channel layers 2224; a top device sub-stack 2230 corresponding to the top device sub-stack 130 and comprising top channel layers 2234; bottom source/drain structures 2226a-b corresponding to the bottom source/drain structures 126; top source/drain structures 2236a-b; and a gate stack 2280 on the bottom channel layers 2224 and the top channel layers 2234. The stacked transistor device 2200 may be a CFET wherein the bottom device of the stacked transistor device 2200 may be of a same conductivity type as the non-stacked transistor device 4120. That is, the bottom source/drain structures 126a-b and 2226a-b may be of a same conductivity type. Additionally, a bottom portion of the gate stack 2280 formed on the bottom channel layers 2226 may be of a same type as the gate stack 480 of the non-stacked transistor device 2100 (e.g. N- or P-type gate stack).

As any remaining portions of channel material have been removed from the top device sub-stack 130 as discussed in connection with Fig. 19 above, there are no seeding surfaces for the top source/drain epitaxy over the bottom device sub-stack 120. As shown in Fig. 21, the top source/drain structures 2236a-b may hence be formed selectively on the uncut top channel layers 2236 of the top device sub-stack 2230. Hence, there is no corresponding top source/drain structure of the non-stacked transistor device 2100 which the top source/drain structure 2236a may merge with (see region in the dashed box). Meanwhile, the bottom source/drain structure 126a of the non-stacked transistor device 2100 and the bottom source/drain structure 2226a of the stacked transistor device 2200 may as shown be formed as a common merged source/drain structure. Source/drain contacts may be formed as outlined above in connection with the first method. For instance, a common source/drain contact may be formed on the common merged bottom source/drain structures 126a, 2226a and the top source drain structure 2236a. Individual source/drain contacts may be formed on the other bottom and top source/drain structures 126b, 2226b, 2236b.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor device, comprising:
forming a device structure on a substrate, the device structure comprising:
a device layer stack comprising a bottom device sub-stack comprising at least one bottom channel layer, and a top device sub-stack comprising at least one top channel layer,
a sacrificial gate structure extending across the device layer stack, and
bottom source/drain structures on opposite ends of the at least one bottom channel layer;
forming an opening exposing the top device sub-stack, wherein forming the opening comprises etching the sacrificial gate structure;
forming a cut through the top device sub-stack by etching back the top device sub-stack from the opening, wherein the etching extends through each of the at least one top channel layer and is stopped over the bottom device sub-stack; and
subsequent to forming the cut, forming a functional gate stack on the at least one bottom channel layer.

2. A method according to claim 1, wherein the opening is formed to expose a top surface of the device layer stack and sidewalls of the bottom and top device sub-stack, and the method further comprises forming in the opening a bottom mask layer surrounding the bottom device sub-stack, and using the bottom mask layer as an etch mask for the bottom device sub-stack during the forming of the cut.

3. A method according to claim 2, wherein forming the bottom mask layer comprises filling the opening with a mask material and etching back the mask material to a level intermediate the at least one top channel layer and the bottom device sub-stack, the etched back mask material forming the bottom mask layer.

4. A method according to claim 3, further comprising removing the bottom mask layer after forming the cut and prior to forming the functional gate stack.

5. A method according to claim 1, wherein the opening is formed to selectively expose a top surface portion of the device layer stack, wherein portions of the sacrificial gate structure remain along sidewalls of the bottom and top device sub-stack after forming the opening.

6. A method according to claim 5, further comprising:
forming a cut mask layer over the device structure;
patterning an aperture in the cut mask layer; and
sequentially transferring the aperture into the sacrificial gate structure and into the top device sub-stack by etching to form the opening and the cut.

7. A method according to any one of the preceding claims, further comprising filling the opening in the sacrificial gate structure and the cut with a dielectric fill material and subsequently removing the sacrificial gate structure.

8. A method according to any one of the preceding claims, further comprising applying, via the cut, an isotropic etching process for removing portions of each of the at least one top channel layer remaining along the cut.

9. A method according to claim 8, wherein the device structure further comprises a gate spacer formed on sidewalls of the sacrificial gate structure, wherein the isotropic etching process removes end portions of each of the at least one top channel layer remaining below the gate spacer after forming the cut.

10. A method according to claim 9, wherein the top device sub-stack comprises a number of channel layers and a number of sacrificial layers alternating the channel layers, wherein end portions of the sacrificial layers are recessed with respect to the end portions of the channel layers and covered by insulating inner spacer portions, wherein the isotropic etching process removes the end portions of each of the at least one top channel layer remaining below the inner spacer portions after forming the cut.

11. A method according to any one of the preceding claims, wherein the device layer stack is a first device layer stack, and the sacrificial gate structure is a first sacrificial gate structure, and the device structure further comprises:
a second device layer stack comprising a bottom device sub-stack comprising at least one bottom channel layer, and a top device sub-stack comprising at least one top channel layer, and
bottom source/drain structures on opposite ends of the at least one bottom channel layer of the bottom device sub-stack of the second device layer stack,
wherein the first sacrificial gate structure, or a second sacrificial gate structure parallel to the first sacrificial gate structure, extends across the second device layer stack;
the method further comprising:
forming by epitaxy top source/drain structures on opposite ends of the at least one top channel layer of the top device sub-stack of the second device layer stack, and
subsequent to forming the cut through the top device sub-stack of the first device layer stack, forming a functional gate stack on the at least one bottom channel layer and the at least one top channel layer of the bottom device sub-stack of the second device layer stack.

12. A method according to claim 11, wherein the top source/drain structures are formed prior to forming the opening and the cut.

13. A method according to claim 11, wherein the device structure further comprises a fin structure comprising the first device layer stack and the second device layer stack, wherein the second sacrificial gate structure extends across the second device layer stack, and wherein one of the bottom source/drain structures is a merged epitaxial source/drain structure formed between the first and second sacrificial gate structures on the respective at least one bottom channel layer of the first and the second device layer stack,
the method further comprising:
applying, via the cut, an isotropic etching process for removing portions of each of the at least one top channel layer of the first device layer sub-stack remaining along the cut; and
subsequent to applying the isotropic etching process, forming the top source/drain structures on opposite ends of the at least one top channel layer of the top device sub-stack of the second device layer stack.

14. A method according to any one of the preceding claims, wherein the device layer stack further comprises a dielectric separation layer intermediate the bottom and top device sub-stacks, and wherein the etching for forming the cut through the top device sub-stack is stopped over or at the separation layer.

15. A method according to any one of claims 1-13, wherein the separation layer is formed of a sacrificial semiconductor material, wherein the etching for forming the cut through the top device sub-stack is stopped over or at the separation layer, and wherein the method further comprises removing the separation layer by selective etching of the sacrificial semiconductor material, after forming the cut and prior to forming the functional gate stack.
